# FASCICULE DE BREVET EUROPEEN

(11) **EP 2 013 863 B1**
(45) Date de publication et mention de la délivrance du brevet: **18.01.2017**
(21) Numéro de dépôt: 07728603.7
(22) Date de dépôt: 27.04.2007
(51) Int. Cl.: G09G 3/3233

(54) **ECRAN ELECTROLUMINESCENT ORGANIQUE**
ORGANISCHES ELEKTROLUMINESZENZDISPLAY
ORGANIC ELECTROLUMINESCENT DISPLAY

(30) Priorité: 28.04.2006 FR 0603863
(43) Date de publication de la demande: 14.01.2009
(73) Titulaire: Thomson Licensing, 92130 Issy-les-Moulineaux (FR)
(72) Inventeur: KRETZ, Thierry, F-38430 Saint Jean de Moirans (FR); LEBRUN, Hugues, F-38500 Coublevie (FR); CHUITON, Elisabeth, F-38420 Revel (FR)
(74) Mandataire: Esselin, Sophie
(86) Numéro de dépôt international: PCT/EP2007/054148
(87) Numéro de publication internationale: WO 2007/125095

(56) Documents cités:
- FR-A1- 2 873 227
- YOU B-H ET AL: "POLARITY-BALANCED DRIVING TO REDUCE VTH SHIFT IN A-SI FOR ACTIVE-MATRIX OLEDS" 2004 SID INTERNATIONAL SYMPOSIUM DIGEST OF TECHNICAL PAPERS. SEATTLE, WA, MAY 25 - 27, 2004, SID INTERNATIONAL SYMPOSIUM DIGEST OF TECHNICAL PAPERS, SAN JOSE, CA : SID, US, vol. VOL. 35 PRT 1, 25 mai 2004 (2004-05-25), pages 272-275, XP001222797

## Description

La présente invention concerne un écran électroluminescent organique, et plus particulièrement un écran électroluminescent organique de type à matrice active, ou AMOLED (*Active Matrix Organic Light Emitting Diode).*

Dans un écran électroluminescent organique, l'élément image (pixel) est une structure à diode électroluminescente organique. Un tel écran ne nécessite pas de source de lumière additionnelle, contrairement à d'autres dispositifs d'affichage tels que les dispositifs dits LCD (*Liquid Crystal Display).* Il a comme autres avantages, de consommer peu, d'avoir une grande brillance, et des coûts de fabrication réduits. Le principe à la base de l'affichage de données vidéo par des diodes OLED est la modulation du courant de la diode. Ceci est obtenu par un transistor de commande en courant, qui reçoit sur sa grille une tension correspondant à la donnée vidéo à afficher et fournit un courant correspondant à la diode.

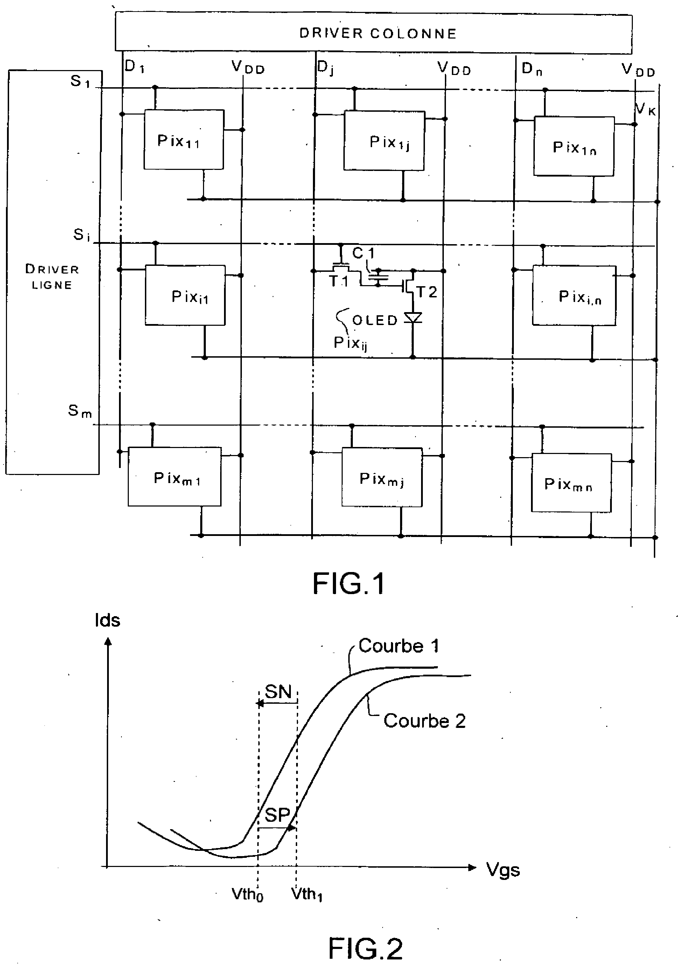

Sur la figure 1 est représenté un schéma électrique équivalent d'un point image ou pixel OLED selon l'état de l'art. Comme illustré sur cette figure, le dispositif comprend de façon habituelle un réseau croisé de lignes de sélection S₁, S₂,...Sₘ, et de lignes de données D₁, D₂,...Dₙ, m et n nombres entiers. A chaque pixel Pix_{i,j} de la matrice correspond une ligne de sélection Si, i∈[1,...m], et une ligne de données Dⱼ, j∈[1,...n], par lesquelles ce pixel est commandé. Chaque pixel Pix_{i,j} comprend une diode électroluminescente organique OLED et un circuit de commande en courant associé. Ce circuit comprend un transistor T1 de commutation, une capacité de maintien C1 et un transistor T2 de commande en courant ("*driving transistor*" dans la littérature anglo-saxonne). Une électrode de grille du transistor de commutation T1 est connectée à la ligne de sélection correspondante Sᵢ et une électrode de conduction, source ou drain, connectée à la ligne de donnée associée Dⱼ. L'autre électrode de conduction est reliée à une borne de la capacité de maintien C1, et à l'électrode de grille du transistor de commande T2. La capacité de maintien C1 a son autre borne connectée à une tension de référence V_{DD}. Le transistor de commande en courant est connecté en série avec la diode électroluminescente organique OLED entre la tension de référence et la masse : l'anode de la diode est ainsi connectée à une électrode de conduction (drain ou source) du transistor T2 et sa cathode est connectée à un potentiel commun VK à toutes les diodes de l'écran, typiquement la masse électrique. Dans l'exemple, les transistors T1 et T2 sont de type N.

De manière habituelle, à chaque nouvelle trame vidéo, les rangées de pixels sont sélectionnées en séquence par l'application sur leur ligne de sélection respective S₁, S₂, ...Sₘ, d'une tension de sélection Vgon, pendant un temps ligne. Les signaux de données vidéo correspondant à une rangée de pixels sélectionnée sont appliqués sur les lignes de données D₁, ...Dⱼ. Ces lignes de sélection et de données sont pilotées par des circuits de commande respectifs, appelés driver ligne et driver colonne, qui peuvent être intégrés à la matrice ou externes. Ces circuits sont bien connus de l'homme de l'art.

Considérons l'élément image Pix_{i,j}. Lorsque la ligne de sélection Sᵢ est adressée, le transistor de commutation T1 devient passant, "on" pendant le temps d'adressage (temps ligne) de la ligne. Il commute la tension vidéo présente sur la ligne de donnée Dⱼ, sur la grille du transistor T2 de commande en courant. Le transistor T1 repasse ensuite à l'état off et isole le pixel de la ligne de donnée. La capacité C1 assure alors le maintien de la tension sur la grille du transistor T2. Le transistor T2 fonctionne comme une source de courant commandée : il fournit à la diode OLED un courant dont l'intensité est fonction de la tension vidéo commutée sur sa grille. La diode OLED émet avec une intensité lumineuse correspondante. Dans ce fonctionnement, le transistor T2 est alimenté en continu : le rapport de cycle d'application de cette tension est donc de 100% pour chaque trame vidéo. La diode est aussi commandée en continu, avec un rapport de cycle de 100%.

L'intensité du courant passant dans le transistor de commande en courant T2 dépend du niveau de tension commuté sur la grille du transistor T2. Elle dépend aussi de la tension de seuil (*threshold voltage*) de ce transistor. On rappelle que la tension de seuil d'un transistor représente la différence de potentiel minimum qu'il faut appliquer entre grille et source du transistor pour que ce dernier passe du courant : en dessous le transistor est dit bloqué. Plus la différence de potentiel est élevée, plus le transistor passe du courant, jusqu'à être dans l'état saturé. Le courant drain-source Ids est donné par l'équation générale suivante : Ids=K(V_{gs}-Vₜₕ)², où Vₜₕ est la tension de seuil, et V_{gs} la tension grille-source.

Pour avoir une bonne luminance et une bonne uniformité de l'écran, le courant Ids correspondant à un niveau de gris donné doit être constant dans le temps quel que soit le pixel de l'écran considéré.

Dans l'invention, on s'intéresse plus particulièrement à des écrans AMOLED, dont les transistors de la matrice active (les transistors T1 et T2 des pixels Pix_{i,j}) sont des transistors en couches minces dits TFT (*Thin Film Transistor*)*,* et notamment à des écrans AMOLED utilisant une matrice active à transistors TFT à silicium amorphe, matrices qui sont avantageusement peu coûteuses. Dans ces écrans, on observe une forte dérive en positif de la tension de seuil du transistor T2 de commande en courant avec le niveau de la tension appliquée sur sa grille en continu (rapport de cycle de 100%). Plus généralement, la tension de seuil de ces transistors varie avec la température, la tension grille source qui lui est appliquée et le rapport de cycle, c'est à dire le temps pendant lequel la tension Vgs est appliquée rapportée à la durée de la trame. Ceci concerne aussi d'autres types de transistors, par exemple des transistors dans des matériaux entre le silicium amorphe et le silicium polycristallin.

Sur la figure 2 est illustrée une courbe 1 typique du courant drain source Ids en fonction de la tension grille source Vgs d'un transistor TFT en silicium amorphe, dans des conditions initiales, avec une tension de seuil Vth₀. Dans l'exemple le transistor est de type N. Un tel transistor à une tension de seuil positive ou nulle. Il est rendu conducteur par l'application d'une tension grille-source positive, supérieure à sa tension de seuil. Après avoir soumis le transistor à un stress positif SP, c'est à dire à une tension grille-source supérieure à la tension de seuil du transistor, pendant une trame (typiquement 20 millisecondes), on obtient une deuxième courbe 2, qui correspond à une translation de la courbe initiale dans le sens des Vgs croissants. Cela signifie que, du fait du stress positif, la tension de seuil du transistor a augmenté, passant de Vth₀ à Vth₁>Vth₀. Ceci a pour effet que pour une même tension grille source, on commandera moins de courant Ids dans le transistor, et donc la diode OLED émettra moins de lumière.

Pour une donnée à afficher donnée, le niveau de lumière obtenu est donc variable suivant la tension de seuil effective du transistor, au moment de l'observation. La tension de seuil dérivant en positif, le courant fourni par les transistors de commande en courant diminue, ce qui se traduit par une perte de luminance sur les écrans AMOLED.

Les tensions vidéo à afficher étant variables d'un pixel à l'autre, cette variation de la tension de seuil des transistors de commande T2 se traduit en outre par une forte non-uniformité sur l'écran AMOLED.

Un objet de l'invention est de résoudre ce problème de dégradation de l'affichage des écrans AMOLEDs dû à la dérive de la tension de seuil des transistors de commande en courant qui pilotent les diodes électroluminescentes organiques.

Une solution à ce problème technique a été trouvée dans l'invention qui consiste principalement à prévoir une phase de récupération de la dérive de la tension de seuil du transistor de commande en courant de chaque pixel. Pendant cette phase de récupération, on bloque le transistor de commande en courant, par une valeur de tension de blocage appliquée sur sa grille. Le transistor subit alors un stress inverse de celui subit pendant la période d'affichage, en sorte que la tension de seuil revienne autour de sa valeur initiale Vth₀. Comme, la diode doit être commandée avec un rapport de cycle de 100%, on prévoit ainsi un premier et un deuxième transistors de commande en courant par diode, commandés de façon appropriée, en sorte que pendant que l'un commande le courant dans la diode, l'autre est bloqué et vice et versa. En moyenne, sur chaque transistor, la dérive de la tension de seuil est nulle.

La publication SID 04 Digest,Vol.35, pages 272-275 "Polarity-Balanced driving to reduce Vth Shift in a-Si for active Matrix OLEDs", par You et al, datée du 25 mai 2004 (XP001222797) propose une structure de pixel à double sélection de ligne utilisant deux lignes de données par point image, pour commander en alternance la phase de récupération sur l'un des transistors de commande et la phase d'affichage sur l'autre pendant les trames paires, et l'inverse pendant les trames impaires.

Dans un contexte d'écran LCD dit séquentiel couleur, la demande de brevet FR 2 873 227 A1 propose d'utiliser une autre ligne de sélection de rangée en plus de la ligne de sélection de rangée courante des pixels pour commander de manière duale dans les pixels, chacun de leurs deux dispositifs d'écriture en mode d'échantillonnage ou en mode de transfert.

Un objet de l'invention est de proposer écran AMOLED offrant de meilleures performances à coût minimal en termes de circuits et de commande d'adressage.

L'invention concerne donc un écran électroluminescent organique comprenant n.m point images organisés matriciellement suivant m rangées et n colonnes, chaque point image comprenant une diode organique (OLED) et un premier et un deuxième circuits de commande en courant (COM,COM') de ladite diode qui comprennent chacun :
- un transistor de commande en courant (T2) connecté entre une tension de référence et une électrode (E1) de ladite diode,
- un transistor de commutation (T1) pour commuter une tension de grille sur la grille dudit transistor de commande en courant,
- une capacité (C1) connectée sur la grille dudit transistor de commande en courant, pour maintenir ladite tension de grille,
un circuit d'adressage desdits n.m points image étant configuré pour commander en alternance une phase de récupération sur un circuit de commande d'un point image par application d'une tension de blocage (Vb) comme tension de grille du transistor de commande en courant respectif et une phase d'affichage sur l'autre circuit de commande du point image, par application d'une tension vidéo (Vᵥ) comme tension de grille du transistor de commande en courant respectif,
caractérisé en ce que
le circuit d'adressage comprend m lignes de sélection de rangée, une par rangée de la matrice et les points images d'une rangée de la matrice sont connectés à une ligne de sélection respective (Si) de ladite rangée et à une autre ligne de sélection d'une autre rangée, et n lignes de données, une par colonne de la matrice, chacune pour appliquer une tension vidéo à un point image d'une colonne respective et d'une rangée courante sélectionnée, et le circuit d'adressage est configuré pour sélectionner en séquence chacune des lignes de sélection de l'écran, dans le sens d'un balayage de l'écran de haut en bas pour une trame, et dans le sens d'un balayage de l'écran de bas en haut pour la trame suivante,
et en ce que dans chaque point image sur une rangée et une colonne respectives de la matrice :
- la ligne de donnée respective (Dᵢ) est connectée aux transistors de commutation (T1, T1') des deux circuits de commande associés,
- la ligne de sélection (Sᵢ) respective est connectée à la grille du transistor de commutation (T1) d'un des deux circuits de commande (COM),
- l'autre ligne de sélection (Sᵢ₋₁) est connectée à la grille du transistor de commutation (T1') de l'autre circuit de commande (COM'), et
- chacun des deux circuits de commande (COM, COM') comprend un transistor supplémentaire (T3, T3') pour appliquer une tension de blocage comme tension de grille du transistor de commande du circuit de commande considéré, ledit transistor étant connecté entre la grille du transistor de commande en courant du circuit de commande considéré et la ligne de sélection qui lui est associée, et commandé sur sa grille par l'autre ligne de sélection associée à l'autre circuit de commande.

Avantageusement, il est fait usage des drivers de commande lignes qui pilotent les lignes de sélection et/ou des drivers colonnes qui pilotent les lignes de données dans les écrans à cristaux liquides (LCD) pour piloter ces circuits de façon appropriée.

D'autres avantages et caractéristiques de l'invention sont détaillés dans la description suivante en référence aux dessins illustrés de modes de réalisation de l'invention, donnés à titre d'exemple non limitatif. Dans ces dessins :
- la figure 1 déjà décrite illustre la structure d'un élément image à diode OLED selon l'état de l'art;
- la figure 2 illustre le phénomène connu de dérive de la tension de seuil d'un transistor ;
- la figure 3 illustre une structure d'élément image à diode OLED pour un circuit d'adressage de n.m points images utilisant m lignes de sélection et 2. n lignes de données pour commander en alternance des phases de récupération et d'adressage des transistors de commande des points OLED;
- les figures 4 et 5 illustrent un mode et une séquence d'adressage correspondants;
- la figure 6 illustre une variante à m lignes de sélection et 2.n lignes de données; et
- les figures 7, 8a et 8b illustrent un mode et des séquences d'adressage correspondants;
- la figure 9 illustre une structure d'élément image à diode OLED pour un circuit d'adressage de n.m points images utilisant 2.m lignes de sélection et n lignes de données pour la commande alternée des phases de récupération et d'adressage;
- la figure 10 illustre un mode d'adressage correspondant ;
- la figure 11 illustre une structure d'élément image à diode OLED pour un circuit d'adressage de n.m points images utilisant m lignes de sélection et n lignes de données pour la commande alternée des phases de récupération et d'adressage; et
- la figure 12 illustrent une séquence d'adressage correspondante.

Dans un souci de clarté et de simplification de l'exposé, les éléments communs aux différentes figures portent les même références. Sur les figures, on note Vg(T2) et Vg(T2'), les tensions appliquées sur les grilles des transistors T2 et T2'.

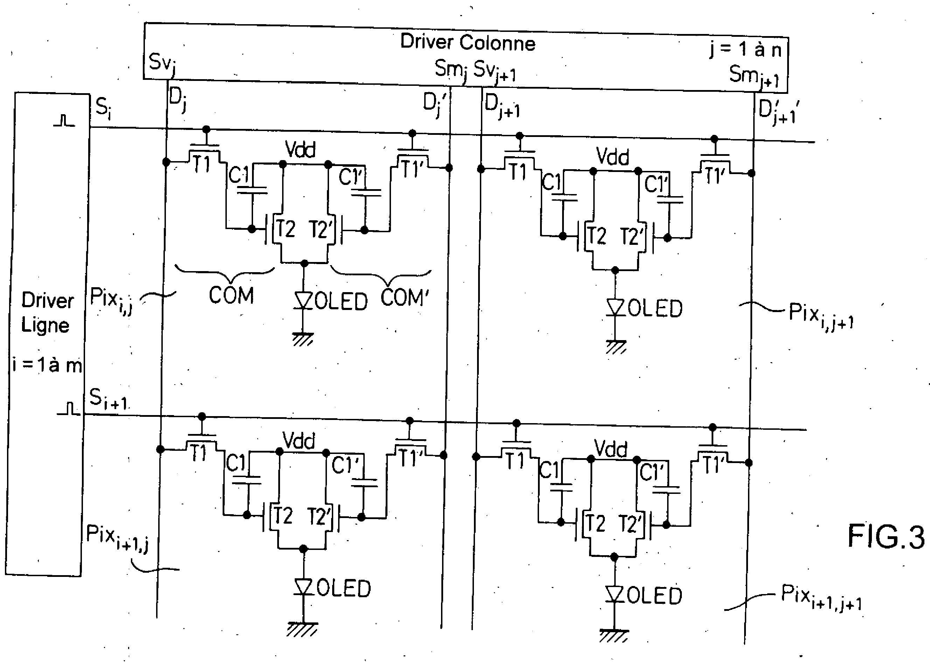

Selon l'invention et comme illustré sur les figures 3, 6, 9 et 11, chaque point (ou élément) image Pix_{i,j} de l'écran électroluminescent organique comprend deux circuits de commande COM et COM' de structure identique, associés à la diode électroluminescente organique OLED de ce point Pix_{i,j}. La diode OLED comprend une première électrode E1 par laquelle elle est commandée en courant, et une deuxième électrode E2 (cathode) connectée à un potentiel VK commun à toutes les diodes de l'écran. Dans la suite, on considère que ce potentiel est la masse électrique et est représenté par un symbole correspondant.

Les deux circuits de commande COM et COM' sont chacun connectés en sortie à l'électrode E1 de la diode OLED. Ils ont une structure identique. Ils comprennent chacun un transistor de commutation, un transistor de commande en courant et une capacité de maintien. Par convention, on note T1, C1 et T2 ces éléments du premier circuit référencé COM et T1', C1' et T2' ces éléments du deuxième circuit référencé COM'.

Selon l'invention, ces circuits COM et COM' sont commandés par des lignes de sélection et/ou de données de la matrice de telle sorte qu'ils aient une fonction différente à chaque trame vidéo, ces fonctions étant inversées périodiquement. Ces fonctions sont : 1.-afficher une information vidéo, par application d'une tension vidéo sur la grille du transistor de commande, pour fournir un courant correspondant à la diode OLED et 2.-compenser le stress occasionné par la première fonction, par des phases de récupération pendant lesquelles une tension de blocage est appliquée sur la grille du transistor de commande.

Ainsi, pendant une trame vidéo donnée, l'un des deux circuits, par exemple le circuit COM, a la fonction d'afficher l'information vidéo via la diode OLED, par application d'une tension vidéo correspondante sur la grille de son transistor T2, alors que l'autre circuit, dans l'exemple COM', a la fonction d'appliquer une tension de blocage sur la grille de son transistor T2', ce qui met ce transistor en phase de récupération de la dérive de tension de seuil, selon l'invention. Les fonctions des deux circuits sont inversées périodiquement : le circuit COM' a alors la fonction d'afficher l'information vidéo, par application d'une tension vidéo correspondante sur son transistor T2', tandis que le circuit COM a la fonction de compenser le stress subit par son transistor T2, en lui appliquant une tension de blocage.

Une trame sur deux en moyenne étant mise à profit pour chaque circuit de commande pour destresser son transistor de commande en courant, la dérive moyenne de la tension de seuil de chaque transistor de commande de la matrice active est nulle ou approximativement nulle. Ceci peut être obtenu sans affecter le rapport de cycle d'application de la tension vidéo sur la diode OLED, en sorte que la diode reste commandée en continue (rapport de cycle de 100%).

La période d'inversion des fonctions des circuits de commande est de préférence, la période trame : à chaque nouvelle trame vidéo, les fonctions des circuits sont inversés. Plus généralement, on peut prévoir une inversion des fonctions tous les K trames, K nombre entier quelconque. On verra qu'un mode d'adressage correspondant des circuits COM et COM' peut être facilement mise en oeuvre en utilisant des drivers ligne et colonne du commerce.

La tension de blocage de la phase de récupération peut-être une tension fixe prédéterminée. Elle est avantageusement variable. Pour chaque point image, elle est avantageusement fonction de la tension vidéo appliquée sur ce point image. En effet, la tension vidéo appliquée varie d'un élément image à l'autre de l'écran. Pour un pixel donné, la tension vidéo varie aussi dans le temps, d'une trame à une autre. La dérive des tensions de seuil est ainsi variable d'un pixel à l'autre. Pour cette raison, en fixant la tension de blocage, on obtient une image avec une luminance non uniforme, malgré la phase de récupération. En prévoyant avantageusement que la tension de blocage soit telle qu'elle applique au transistor de commande en courant un stress d'amplitude inverse de la tension vidéo, on met en oeuvre une récupération intelligente de la dérive de la tension de seuil.

Considérons le mode de réalisation selon l'invention illustré à la figure 3. L'écran comporte n.m pixels Pix_{i,j}, i= 1 à m ; j=1 à n. Il comprend m lignes de sélection Sᵢ, chaque ligne permettant d'adresser n pixels de l'écran. Il comprend 2.n lignes de données Dⱼ et Dⱼ', qui permettent d'appliquer une tension vidéo et une tension de blocage sur chacun des n pixels d'une ligne de sélection.

Plus précisément, à chaque élément image Pix_{i,j} correspond une ligne de sélection Sᵢ à laquelle sont connectées les grilles des transistors de commutation T1 et T1', une première ligne de donnée Dⱼ et une deuxième ligne de données Dⱼ'. La première ligne de donnée Dⱼ est connectée au transistor de commutation de l'un des circuits de commande, et la deuxième ligne de donnée Dⱼ' est connectée au transistor de commutation de l'autre circuit de commande. Ainsi dans l'exemple, Dⱼ est connectée au transistor de commutation T1 du circuit COM et Dⱼ' est connectée au transistor de commutation T1' du circuit COM'.

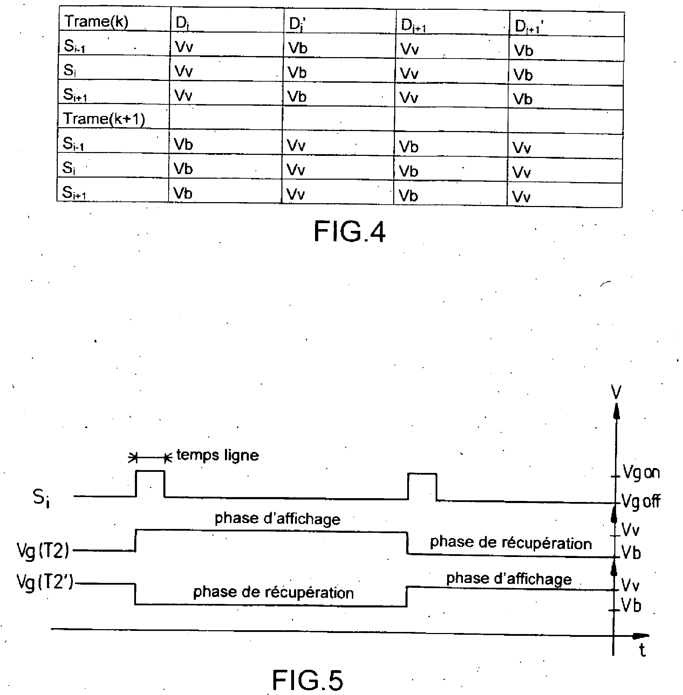

Comme illustré sur la figure 4, pendant une trame vidéo k donnée, la ligne de donnée Dⱼ va fournir la tension vidéo Vv et la ligne de donnée Dⱼ' va fournir la tension de blocage Vb. C'est le transistor de commande en courant T2 qui fournira alors le courant à la diode OLED, tandis que le transistor T2' sera en phase de récupération.

Pendant une autre trame vidéo, par exemple la trame suivante k+1, ce sera l'inverse : la ligne Dⱼ va fournir la tension de blocage Vb et la ligne de donnée Dⱼ' va fournir la tension vidéo Vv. C'est alors le transistor de commande en courant T2' qui fournira le courant à la diode OLED, tandis que le transistor T2 sera en phase de récupération.

Un exemple de séquence d'adressage correspondant est illustré schématiquement sur la figure 5, qui met en évidence le comportement dual des transistors T2 et T2' : quand l'un est en phase d'affichage, l'autre est en phase de récupération et inversement.

On a vu que la tension de blocage Vb appliquée sur un pixel est une tension fixe prédéterminée, ou avantageusement une tension variable d'un pixel à l'autre, fonction de la tension vidéo appliquée sur le pixel.

On peut utiliser avantageusement comme driver colonne, pour piloter les 2n lignes de données d'un écran suivant le mode de réalisation de la figure 3, un driver colonne habituellement utilisé dans les écrans à cristaux liquides LCD. En effet, ces drivers sont conçus pour fournir une tension dite tension miroir, fonction de la tension vidéo appliquée. Plus précisément, ils fournissent de manière habituelle en sortie, pour une rangée de pixels donnée, la tension vidéo à appliquer sur chaque ligne de donnée Dⱼ de la matrice, fonction du signal vidéo DATA VIDEO reçu en entrée, ou une tension miroir correspondante. Rappelons que le point image d'un écran LCD est une cellule à cristaux liquides avec une électrode pixel, sur laquelle on applique la tension vidéo, et une contre-électrode commune à tous les pixels, portée à une tension de référence. La tension miroir d'une tension vidéo donnée, est telle que le sens du champ électrique aux bornes du pixel est inversé, mais permet d'obtenir la même luminance (le même niveau de gris). Les drivers colonnes des écrans LCD fournissent ainsi habituellement en sortie, pour chaque ligne de donnée de la matrice, l'une ou l'autre tension, suivant la trame, inversion trame, et/ou suivant la colonne de pixel concernée, inversion colonne. En inversion colonne, on aura ainsi le fonctionnement suivant : sur une trame, on applique la tension vidéo sur les lignes de données Dⱼ, Dⱼ₊₂, Dⱼ₊₄; et la tension miroir sur les lignes de données Dⱼ₊₁, Dⱼ₊₃, Dⱼ₊₅. A la trame suivante, c'est l'inverse : la tension miroir est appliquée sur les lignes de données Dⱼ, Dⱼ₊₂, Dⱼ₊₄ ; et la tension vidéo est appliquée sur les lignes de données Dⱼ₊₁, Dⱼ₊₃, Dⱼ₊₅ ainsi de suite. Ceci permet de manière connue d'éviter un phénomène dit de marquage, en alternant le sens du champ électrique sur les pixels, et de réduire la consommation.

La tension miroir est définie par rapport à la tension de contre-électrode pour obtenir le même coefficient de transmission sur le pixel qu'avec la tension vidéo. On parle généralement de tension positive pour la tension vidéo et de tension négative pour la tension miroir.

Ainsi la tension miroir a une amplitude inverse correspondante à la tension vidéo : cette définition s'applique très bien à la notion de tension de blocage variable, fonction de la tension vidéo : il s'agit d'appliquer un stress en tension, d'amplitude inverse, négative par rapport au stress en tension provoqué par la tension vidéo qui commande la conduction en courant. La valeur de cette amplitude inverse est en pratique déterminée par mesure, de manière à compenser de façon optimale le stress apporté par la tension vidéo.

La tension de blocage à appliquer pour compenser une tension vidéo d'amplitude donnée peut être déterminée par des mesures appropriés. On peut ainsi définir une table de correspondance applicable à un écran donné. Il suffit alors d'utiliser des valeurs de résistances appropriées dans le circuit diviseur de tension qui fournit habituellement les niveaux de tension vidéo et de tension miroir correspondantes.

On peut ainsi utiliser un tel driver colonne d'écran LCD pour commander les lignes de données d'un écran tel qu'illustré en figure 3 : il suffit de sortir pour chaque colonne j de pixel, les deux sorties tension vidéo Svⱼ et tension miroir Smⱼ, de connecter ces deux sorties la première sur la ligne de donnée Dⱼ et la deuxième sur la ligne de donnée Dᵢ', et de commander ce driver colonne en inversion colonne (Figure 4) : sur une trame k, le driver colonne applique la tension vidéo sur les lignes de données Dⱼ et la tension miroir, de blocage, sur les lignes de données Dⱼ'; à la trame suivante, c'est l'inverse : le driver colonne applique la tension miroir, de blocage sur les lignes de données Dⱼ ; et la tension vidéo sur les lignes de données Dⱼ', et ainsi de suite, par exemple de trame en trame.

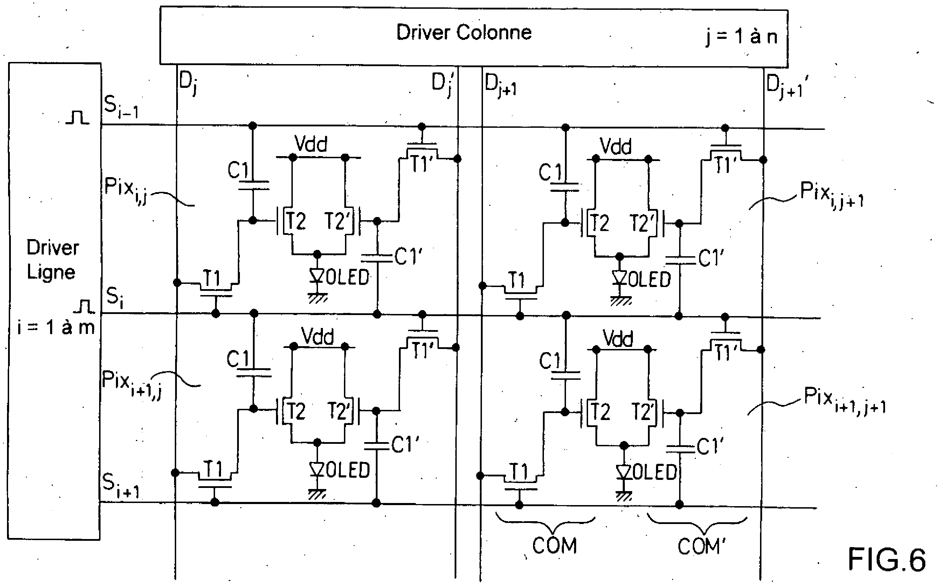

La figure 6 illustre un autre mode de réalisation de l'invention. Comme dans le mode illustré à la figure 3, l'écran comprend n.m pixels Pix_{i,j}, i= 1 à m ; j=1 à n. Il comprend m lignes de sélection Sᵢ, chaque ligne permettant d'adresser n pixels de l'écran. Il comprend 2.n lignes de données Dⱼ et Dⱼ', qui permettent d'appliquer une tension vidéo et une tension de blocage sur chacun des n pixels d'une ligne de sélection. Comme précédemment. Il se distingue de la réalisation précédente vue en relation avec la figure 3a, en ce que la commande des deux circuits de commande COM et COM' utilise à la fois deux lignes de sélection de l'écran Sᵢ et Sᵢ₋₁, et deux lignes de données Dⱼ et Dⱼ'.

Ce mode de réalisation correspond un mode d'adressage de la matrice dit à balayage vertical inversé : pendant une trame, les lignes de sélection sont séquentiellement adressées dans le sens haut vers bas, et à la trame suivante elles sont adressées séquentiellement adressées dans le sens bas vers haut.

De manière plus détaillée, dans ce mode de réalisation de l'invention on fait correspondre à chaque élément image Pix_{i,j}, la ligne de sélection Si à laquelle est connectée la grille du transistor de commutation de l'un des circuits de commande et une autre ligne de sélection de la matrice, de préférence la ligne de sélection précédente Sᵢ₋₁, à laquelle est connectée la grille du transistor de commutation de l'autre circuit de commande. A chaque pixel Pix_{i,j}, on fait en outre correspondre une première ligne de donnée Dⱼ et une deuxième ligne de données Dⱼ'. La première ligne de donnée Dⱼ est connectée au transistor de commutation de l'un des circuits de commande, et la deuxième ligne de donnée Dⱼ' est connectée au transistor de commutation de l'autre circuit de commande. Ainsi dans l'exemple, la grille du transistor de commutation T1 du circuit COM est connectée à Sᵢ, la grille du transistor de commutation T1' du circuit COM' est connectée à Sᵢ₋₁ ; Dᵢ est connectée au transistor de commutation T1 du circuit COM et Dⱼ' est connectée au transistor de commutation T1' du circuit COM'.

Dans l'exemple, on a illustré une variante de connexion de la capacité de maintien des circuits de commande COM et COM' : la capacité de maintien de l'un des circuits de commande est connectée à la ligne de sélection qui commande la grille du transistor de commutation de l'autre circuit de commande. Ainsi la capacité de maintien C1 du circuit de commande COM est connectée à la ligne de sélection Sᵢ₋₁ qui est connectée à la grille du transistor T1' du circuit de commande COM.' La capacité de maintien C1' du circuit de commande COM' est connectée à la ligne de sélection Sᵢ qui est connectée à la grille du transistor T1 du circuit de commande COM. On pourrait comme précédemment avoir les capacités C1 et C1' connectées à la tension de référence Vdd.

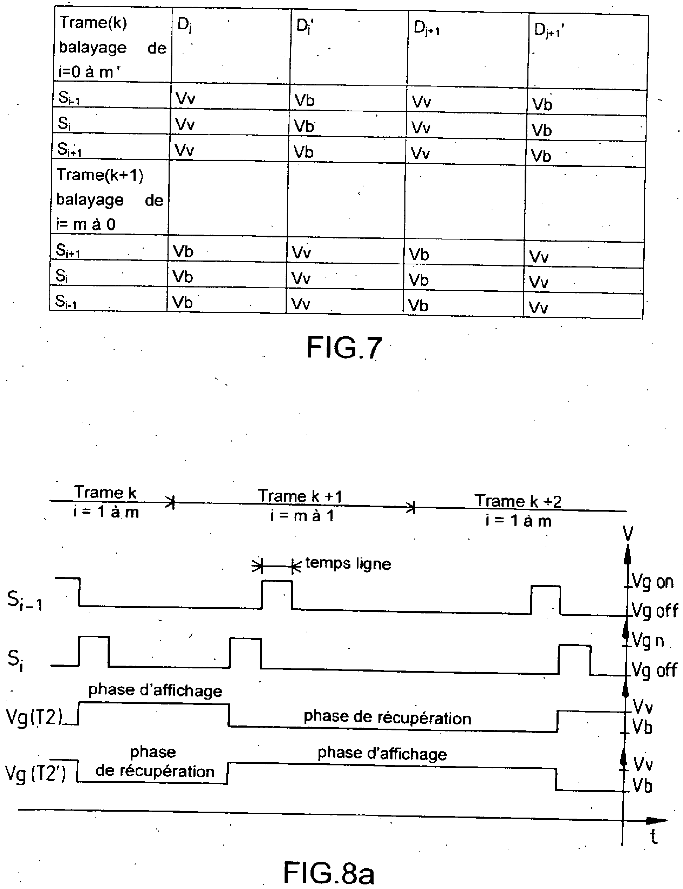

Le mode de fonctionnement va alors être le suivant :
Pendant une trame vidéo, la trame k par exemple, les lignes de sélection sont balayées en séquence du haut vers le bas, c'est à dire dans le sens des indices i croissants de 1 à m (figure 1). Dans ce cas et comme illustré sur la figure 7, les lignes de données Dⱼ sont pilotées pour transmettre les tensions vidéo et les lignes de données Dⱼ' sont pilotées pour transmettre les tensions de blocage.
   Lorsque la ligne de sélection Sᵢ₋₁ est adressée, par application pendant un temps ligne correspondant d'un niveau de tension Vgon, le transistor de commutation T1' du circuit COM' est passant. Il commute la tension de blocage présente à ce moment sur la colonne Dⱼ' sur la grille du transistor T2' : le transistor T2' entre en phase de récupération.
   Lorsque la ligne de sélection Sᵢ est adressée au temps ligne suivant, par application pendant le temps ligne correspondant, d'un niveau de tension Vgon, le transistor de commutation T1 du circuit COM est passant. Il commute la tension vidéo présente à ce moment sur la colonne Dⱼ sur la grille du transistor T2 : le transistor T2 entre en phase d'affichage, et fournit le courant à la diode OLED.
Pendant la trame suivante k+1, les lignes de sélection sont balayées en séquence dans le sens inverse, c'est à dire du bas vers le haut ou encore dans le sens des indices i décroissants de m vers 1 (figure 1) et le rôle des lignes de données Dⱼ et Dⱼ' est inversé : les lignes Dⱼ transmettent les tensions de blocage et les lignes D_{j'} transmettent les tensions vidéo (figure 7). Lorsque la ligne de sélection Sᵢ est adressée, par application pendant un temps ligne correspondant d'un niveau de tension Vgon, le transistor de commutation T1 du circuit COM est passant. Il commute la tension de blocage présente sur la ligne de donnée Dⱼ, sur la grille du transistor T2 et la capacité de maintien associée C1. Le transistor T2 est en phase de récupération. Lorsque la ligne de sélection Sᵢ₋₁ est ensuite adressée, par application pendant un temps ligne correspondant d'un niveau de tension Vgon, le transistor de commutation T1' du circuit COM' est passant. Il commute la tension vidéo présente sur la ligne de donnée Dⱼ', sur la grille du transistor T2' et la capacité de maintien associée C1'.
Pendant cette trame k+1, c'est le transistor T2' qui est en phase d'affichage et le transistor T2 qui est en phase de récupération.

Une séquence d'adressage correspondante est illustrée sur la figure 8a. Elle met en évidence que les durées respectives de phase d'affichage et de récupération ne sont pas égales pour les deux transistors T2 et T2' d'un pixel, du fait de l'alternance du balayage vertical. Dans l'exemple illustré, la phase de récupération du transistor T2 est plus longue que sa phase d'affichage. Pour le transistor T2', c'est l'inverse. En pratique les durées des phases d'affichage et de récupération des transistors T2 et T2' d'un pixel Pix_{i,j} dépendent du rang i de la ligne de sélection correspondante Sᵢ. En pratique, un temps de repos est prévu entre la fin du balayage des lignes d'une trame et le début du balayage des lignes de la trame suivante.

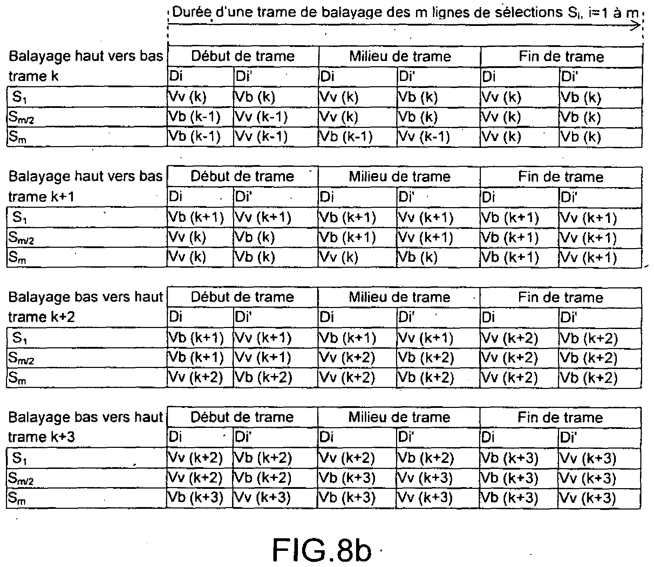

Pour converger vers des durées proches voire égales entre le balayage haut bas et bas haut on peut :
- adresser rapidement la matrice puis laisser un temps de repos avant le balayage suivant.
- balayer X fois toujours dans le même sens avant de commuter sur un balayage de X fois dans l'autre sens. Le tableau de la figure 8b est une illustration qu'une telle alternance du balayage toutes les X =2 trames, on arrive à équilibrer les temps de récupération et vidéo entre COM et COM'. Sur cette figure, Vv(k) et Vb(k) représente les tensions vidéo et de blocage commutées sur les grilles des transistors T2 et T2' des pixels pour la ligne de sélection considérée appliquée pendant la trame k. Tant que la ligne de sélection considérée n'est pas sélectionnée, on a les niveaux de tension des grilles des transistors T2 et T2' sont ceux appliqués à la trame précédente k-1. Dans le tableau, on montre l'évolution des niveaux de tension pendant le temps trame, et pour quatre trames successives, pour une ligne du haut de l'écran, dans l'exemple S₁, du milieu de l'écran (S_{m/2}), et du bas de l'écran (Sₘ).

La tension de blocage peut être fixe ou fonction de la tension vidéo. Dans ce dernier cas, et comme dans le mode de réalisation vu en relation avec la figure 3, on peut avantageusement utiliser un driver colonne de l'état de l'art des écrans LCD, pour adresser les lignes de données d'un écran suivant la figure 6. Le driver sera alors utilisé pour piloter les lignes de données Dⱼ, Dⱼ' comme décrit dans le mode de réalisation précédent, avec en plus l'inversion de la présentation des données vidéo selon le sens de balayage des lignes de sélection Sᵢ. Par exemple, sur une trame, le driver colonne applique la tension vidéo sur les lignes de données Dⱼ ; et la tension miroir, de blocage, sur les lignes de données Dⱼ', et ce dans l'ordre successif des lignes Sᵢ balayées de haut en bas. A la trame suivante, c'est l'inverse : le driver colonne applique la tension miroir, de blocage sur les lignes de données Dⱼ' et la tension vidéo sur les lignes de données Dⱼ, et ce dans l'ordre successif des lignes Sᵢ balayées de bas en haut, et ainsi de suite de trame en trame.

On notera que le mode de réalisation de la figure 6 dans lequel les capacités de maintien sont connectées entre la grille d'un transistor de commande et une ligne de sélection, combiné à l'alternance du balayage progressif des lignes de sélection permet d'empêcher des couplages indésirables via C1 ou C1'.

Dans les modes de réalisation de la figure 3 et 6, les circuits de commande COM et COM' sont identiques au circuit de l'état de l'art (Figure 1). La commande alternée de leurs transistors de commande en courant T2 et T2' étant obtenu par les lignes de sélection et de données qui pilotent leur transistors de commutation T1 et T1', en doublant le nombre de lignes de données à piloter.

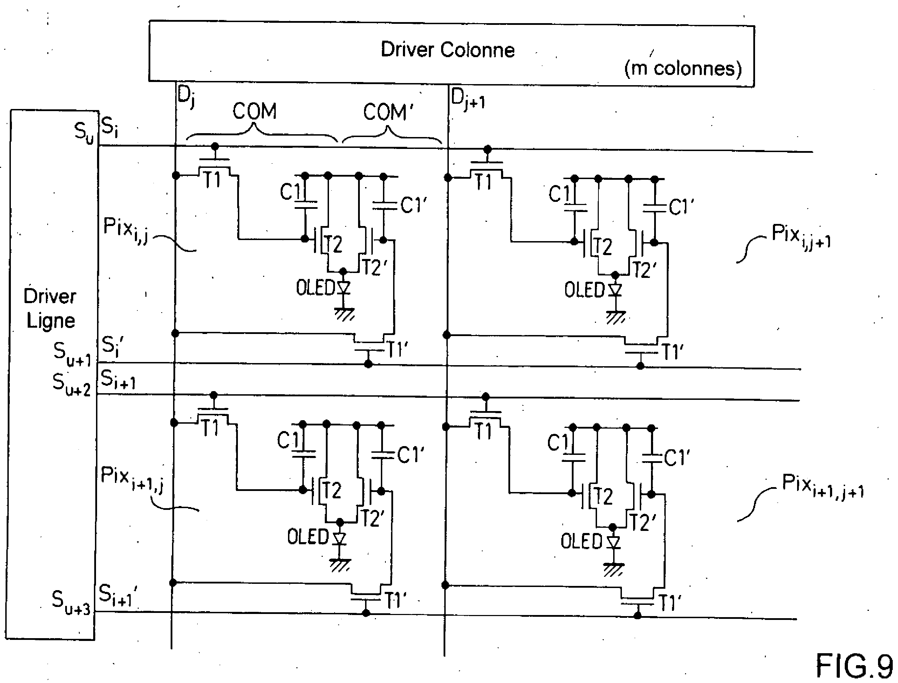

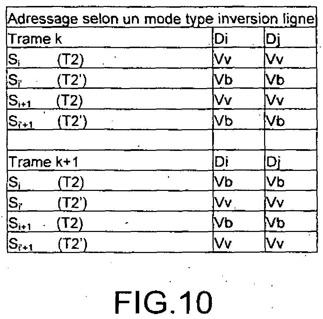

Dans une variante illustrée sur les figures 9 et 10, au lieu de d'utiliser les lignes de données pour permettre l'alternance des fonctions d'affichage et de récupération des circuits de commande COM et COM', on utilise les lignes de sélection : au lieu de doubler le nombre de lignes de données, on double les lignes de sélection.
Comme illustré sur la figure 9, on a alors 2.m lignes de sélection, deux par pixel, et m lignes de données associées aux n.m pixels Pix_{i,j} de l'écran, et on adresse la matricedans un mode type inversion ligne : sur les lignes paires on applique la tension vidéo et sur les lignes impaires on applique la tension de blocage (phase de récupération) et on inverse tout à la trame suivante.

Un avantage de reporter sur le driver ligne la commande de l'alternance des fonctions d'affichage et de récupération des circuits de commande COM et COM' réside dans ce que les drivers lignes sont moins coûteux que les drivers colonnes en termes de complexité et de place. De plus, ces drivers peuvent être facilement intégrés sur le verre et notamment en technologie silicium amorphe.

Dans ce mode de réalisation, la grille du transistor de commutation d'un circuit de commande est connectée à la ligne de sélection du pixel Pix_{i,j}, et la grille du transistor de commutation de l'autre circuit de commande est connectée à une autre ligne de sélection que l'on note Sᵢ'. Les lignes Sᵢ et Sᵢ' sont deux lignes successives du driver ligne Sᵤ et Sᵤ₊₁, avec u=1 à 2m, et i=1 à m.

L'adressage de la matrice peut s'apparenter à un adressage type inversion ligne pour le LCD avec les lignes de sélection Sᵢ qui adressent la vidéo et les lignes Sᵢ' qui adressent la récupération et inversement à la trame suivante.

Un mode d'adressage de la matrice correspondant est illustré sur le tableau de la figure 10, qui met en évidence le comportement dual des transistors T2 et T2', en relation avec la figure 9.

Considérons le pixel Pix_{i,j}.

Pendant une trame k, lorsque la ligne Sᵤ=Sᵢ est adressée, le transistor T1 est passant et commute la tension vidéo Vv présente à ce moment sur la ligne de donnée Dⱼ, sur la grille du transistor T2 et la capacité C1.

Lorsque la ligne Sᵤ₊₁=Sᵢ' est adressée, le transistor T1' est passant et commute la tension vidéo Vb présente à ce moment sur la ligne de donnée Dⱼ, sur la grille du transistor T2' et la capacité C1'.
Au niveau de la commande du driver colonne, l'alternance vidéo/récupération pour les circuits de commande d'un pixel donné est fait sur la même colonne : on a un temps pour afficher la tension vidéo et un temps pour envoyer la tension de récupération. Le nombre de lignes ayant doublé (u=2.m), le temps ligne est divisé par 2.
La tension de blocage peut être la tension vidéo inverse de la vidéo qui a été appliquée la trame précédente (sortie driver colonne) ou bien une tension de reset prédéterminée. Cette tension de reset peut alors par exemple être appliquée sur les colonnes par multiplexage, en utilisant un schéma de driver intégré colonne à 3 transistors TFT, tel que celui décrit dans la demande EP0815552 : soit la sortie driver est envoyée sur les colonnes soit la tension de reset.

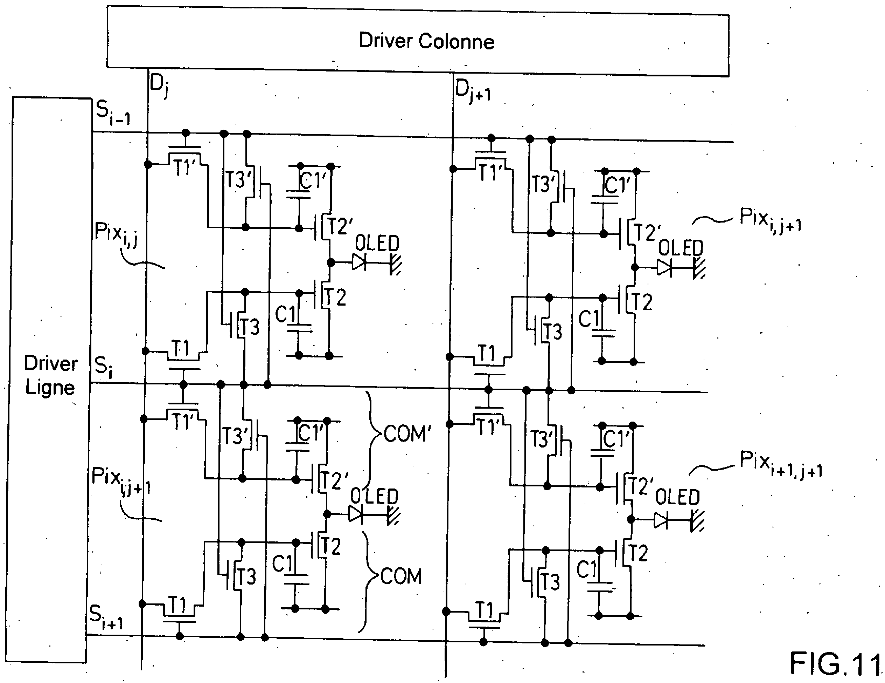

Un autre mode de réalisation de l'invention est illustré sur la figure 11. Ce mode de réalisation a l'avantage par rapport aux deux modes de réalisation décrits précédemment d'utiliser les seules lignes de sélection et de données habituelles, de l'écran. On a donc pour un écran de n.m pixels, m lignes de sélection Sᵢ et n lignes de données Dⱼ comme dans l'état de l'art (Figure 1). En d'autres termes, elle ne nécessite pas de doubler les lignes de données, contrairement aux modes illustrés aux figures 3, 6 et 9. Ceci est un avantage précieux en termes de topologie de circuit (croisement de lignes, commande des lignes) et d'espace occupé.
Ceci est obtenu en prévoyant dans le circuit de commande un transistor de commutation supplémentaire, par lequel on va assurer la commande alternée des transistors de commande en courant. On note T3 pour le circuit COM et T3' pour le circuit COM' ce transistor supplémentaire du circuit de commande.

De manière plus détaillée, dans ce mode de réalisation de l'invention, on fait correspondre à chaque élément image Pix_{i,j}, une seule ligne de donnée Dⱼ qui est connectée aux transistors de commutation T1 et T1' des deux circuits de commande COM et COM', une première ligne de sélection Sᵢ à laquelle est connectée la grille du transistor de commutation de l'un des circuits de commande et une autre ligne de sélection de la matrice, de préférence la ligne précédente Sᵢ₋₁, à laquelle est connectée la grille du transistor de commutation de l'autre circuit de commande. Dans l'exemple, Sᵢ est connectée à la grille du transistor de commutation T1 du circuit COM, Sᵢ₋₁ est connectée à la grille du transistor de commutation T1' du circuit COM'. Les éléments T1, C1 et T2 du circuit COM et T1', C1' et T2' du circuit COM' sont connectés entre eux et à la diode comme précédemment (figures 1, 3, 6).

Le transistor de commutation supplémentaire prévu dans chaque circuit de commande, est connecté entre la grille du transistor de commande en courant et la grille du transistor de commutation. La grille de ce transistor supplémentaire est connectée à la ligne de sélection associée à l'autre circuit de commande. Ainsi, dans l'exemple illustré, le circuit de commande COM comprend un transistor supplémentaire T3, connecté entre la grille du transistor de commutation T1 et la grille du transistor de commande en courant T2. Ce transistor supplémentaire a sa grille connectée à la ligne de sélection Sᵢ₋₁. De façon similaire, le circuit de commande COM' comprend un transistor supplémentaire T3', connecté entre la grille du transistor de commutation T1' et la grille du transistor de commande en courant T2'. Ce transistor supplémentaire a sa grille connectée à la ligne de sélection Sᵢ.

Sur la figure, la capacité de maintien dans chaque circuit de commande est connectée à la tension de référence V_{DD}. On pourrait aussi bien connecter la capacité de maintien comme sur la figure 6.

Les transistors de commutation T3 et T3' dans chaque circuit de commande permettent d'obtenir le blocage alterné des transistors de commande en courant, par commutation du niveau de tension Vgoff des lignes de sélection non adressées. En effet, chaque ligne de sélection est forcée à un niveau Vgoff, tant qu'elle n'est pas adressée. Ce niveau Vgoff est tel que le transistor de commutation est bloqué. Quand elle est adressée, elle est portée pendant un temps ligne à un niveau de tension Vgon, en sorte que les transistors de commutation connectés à cette ligne passe à l'état "on" et commutent la tension présente sur la ligne de donnée, sur la grille du transistor de commande en courant. Dans l'exemple illustré, les transistors T1, T2, T3, T1', T2', T3' sont tous de même type, N dans l'exemple, pour être commutés à l'état on par un niveau Vgon sur leur grille et à l'état off par un niveau Vgoff sur leur grille.

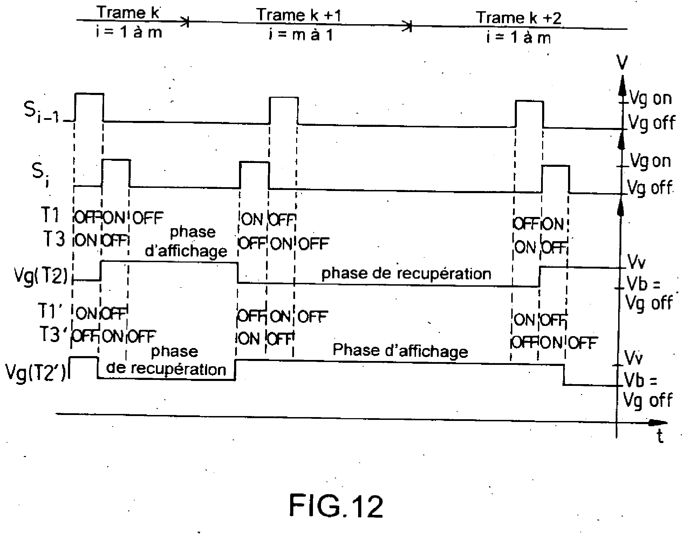

Un exemple de séquence d'adressage correspondant est illustré schématiquement sur la figure 12, qui met en évidence le comportement dual des transistors T2 et T2'.

Ce mode de réalisation utilise un mode d'adressage à balayage vertical inversé, pour assurer la commande duale des deux circuits de commande en courant, de manière alternée.

Dans ce mode de réalisation, on utilise donc le niveau Vgoff comme tension de blocage des transistors de commande en courant, que l'on commute de manière appropriée par les transistors supplémentaires T3.

Le fonctionnement est alors le suivant :
Pendant la trame k, l'écran est balayé du haut vers le bas. Lorsque la ligne de sélection Sᵢ₋₁ est adressée, les transistors T1' et T3 sont commutés à l'état passant "on" pendant le temps ligne correspondant. La ligne de sélection Sᵢ n'est à ce moment pas adressée, et au niveau Vgoff. Les transistors T1 et T3' sont bloqués, "off".
   Le transistor T1' commute la tension vidéo présente à ce moment sur la ligne de donnée Dⱼ sur la grille du transistor de commande en courant T2' : le transistor T2' délivre le courant nécessaire à commander la diode. Le transistor T3 commute le niveau Vgoff présent sur la ligne Si, sur la grille du transistor de commande en courant T2, ce qui met ce transistor T2 à l'état bloqué, en phase de récupération.
   Puis la ligne de sélection Sᵢ₋₁ est désélectionnée, ramenée au niveau de tension Vgoff et la ligne de sélection Si est adressée, portée au niveau Vgon pendant le temps ligne correspondant. Les transistors T1 et T3' sont commutés à l'état passant "on". Les transistors T1' et T3 passent à l'état bloqués "off". Le transistor T1 commute la tension vidéo présente à ce moment sur la ligne de donnée Dᵢ sur la grille du transistor de commande en courant T2. Le transistor T3' commute le niveau de tension Vgoff présent à ce moment sur la ligne de sélection Sᵢ₋₁ sur la grille du transistor de commutation T2', qui est alors bloqué, en phase de récupération.
   Ainsi, le transistor T2 après avoir été bloqué, en phase de récupération pendant le temps ligne précédent (adressage de la ligne de sélection de Sᵢ₋₁), fournit le courant correspondant à la tension vidéo appliquée, à la diode OLED pendant tout le reste de la trame.
Pendant la trame suivante k+1, le sens de balayage de l'écran est inversé, la ligne Sᵢ est ainsi adressée avant la ligne Sᵢ₋₁. Le rôle des différents transistors du pixel Pix_{i,j} est inversé.
   Lorsque la ligne de sélection Sᵢ est adressée, les transistors T1 et T3' sont passants "on". A ce moment la ligne de sélection Sᵢ₋₁ qui n'est pas adressée, est à un niveau de tension Vgoff. Les transistors T1' et T3 sont donc bloqués "off". Le transistor T1 commute la tension vidéo présente à ce moment sur la ligne de donnée Dⱼ est transférée sur la grille du transistor de commande en courant T2. Le transistor T2 fournit le courant à la diode OLED. Le transistor T3' commute le niveau Vgoff sur la grille du transistor de commande en courant T2', bloquant ce transistor, en phase de récupération.
   Lorsque la ligne de sélection Sᵢ₋₁ est ensuite adressée, les transistors T1' et T3 deviennent passants "on". La ligne de sélection Sᵢ qui n'est plus adressée, est à un niveau Vgoff. Les transistors T1 et T3' deviennent bloqués "off".
   Le transistor T1' commute la tension vidéo présente à ce moment sur la ligne de donnée Dⱼ, sur la grille du transistor de commande en courant T2', qui devient passant et commande le courant dans la diode OLED. Le transistor T3 commute le niveau Vgoff sur la grille du transistor T2, ce qui bloque ce transistor, en phase de récupération.
   Ainsi, le transistor T2' après avoir été bloqué, en phase de récupération pendant le temps ligne précédent (adressage de la ligne de sélection de Sᵢ), fournit ensuite le courant correspondant à la tension vidéo appliquée, à la diode OLED pendant tout le reste de la trame. Pendant que le transistor T2' est bloqué, c'est le transistor T2 qui fournit le courant à la diode OLED.

Des variantes de réalisation sont envisageables. Par exemple la grille et le drain des transistors supplémentaires T3 et T3' peuvent être connectées aux lignes de sélection selon des arrangements différents. Ce qui compte, c'est d'obtenir la commande de commutation de Vgoff au bon moment. En considérant les pixels de la ligne de sélection Sᵢ, on peut par exemple connecter la grille des transistors T3 à la ligne de sélection précédente Sᵢ₋₁ et son drain à la ligne de sélection courante Sᵢ, et la grille des transistors T3' à la ligne de sélection précédente Sᵢ₊₁ et leur drain à la ligne de sélection Sᵢ.

Comme dans le mode de réalisation expliqué en relation avec la figure 6, les durées des phases d'affichage et de récupération ne sont pas égales pour les deux transistors T2 et T2'. On peut faire converger ces durées en appliquant les mêmes principes expliqués en page 13, lignes 19 et suivantes.

Dans les modes de réalisation qui viennent d'être décrits à titre d'exemples de la mise en oeuvre de l'invention, ou dans des variantes de ces modes qui en découlent, et en particulier pour les modes de réalisation vues en relation avec les figures 3, 4 et 6, on utilisera avantageusement les drivers colonnes habituellement utilisés dans les écrans à cristaux liquides LCD, qui fournissent ainsi avantageusement une tension de blocage variable, fonction de la tension vidéo, et dont les différents modes d'adressage (inversion ligne, colonne, point, trame) permettent de commander la diode avec un rapport de cycle de 100%, tout en assurant l'alternance des phases d'affichage et de récupération sur les transistors de commande en courant.

L'homme du métier sait utiliser ces différents modes d'adressage de manière appropriée avec un écran électroluminescent organique selon l'invention, en utilisant les sorties de tension miroir du driver comme sorties de tension de blocage des transistors de commande en courant, de manière à obtenir le fonctionnement recherché, avec l'alternance tension vidéo/ tension de blocage sur chacun des différents transistors de commande de l'écran. La tension de blocage est alors fonction de la tension vidéo appliquée.

L'invention qui vient d'être décrite s'applique tout particulièrement aux écrans électroluminescents organiques, qui utilisent une matrice active à transistors TFT (silicium amorphe). Elle s'applique de manière plus générale aux écrans électroluminescents organiques à matrice active.

## Revendications

1. Ecran électroluminescent organique comprenant n.m point images organisés matriciellement suivant m rangées et n colonnes, chaque point image comprenant une diode organique (OLED) et un premier et un deuxième circuits de commande en courant (COM,COM') de ladite diode qui comprennent chacun :
- un transistor de commande en courant (T2) connecté entre une tension de référence et une électrode (E1) de ladite diode,
- un transistor de commutation (T1) pour commuter une tension de grille sur la grille dudit transistor de commande en courant,
- une capacité (C1) connectée sur la grille dudit transistor de commande en courant, pour maintenir ladite tension de grille,
un circuit d'adressage desdits n.m points image étant configuré pour commander en alternance une phase de récupération sur un circuit de commande d'un point image par application d'une tension de blocage (Vb) comme tension de grille du transistor de commande en courant respectif et une phase d'affichage sur l'autre circuit de commande du point image, par application d'une tension vidéo (Vᵥ) comme tension de grille du transistor de commande en courant respectif,
**caractérisé en ce que**
le circuit d'adressage comprend m lignes de sélection de rangée, une par rangée de la matrice et les points images d'une rangée de la matrice sont connectés à une ligne de sélection respective (Si) de ladite rangée et à une autre ligne de sélection d'une autre rangée, et n lignes de données, une par colonne de la matrice, chacune pour appliquer une tension vidéo à un point image d'une colonne respective et d'une rangée courante sélectionnée, et le circuit d'adressage est configuré pour sélectionner en séquence chacune des lignes de sélection de l'écran, dans le sens d'un balayage de l'écran de haut en bas pour une trame, et dans le sens d'un balayage de l'écran de bas en haut pour la trame suivante,
et **en ce que** dans chaque point image sur une rangée et une colonne respectives de la matrice :
- la ligne de donnée respective (Dⱼ) est connectée aux transistors de commutation (T1, T1') des deux circuits de commande associés,
- la ligne de sélection (Sᵢ) respective est connectée à la grille du transistor de commutation (T1) d'un des deux circuits de commande (COM),
- l'autre ligne de sélection (Sᵢ₋₁) est connectée à la grille du transistor de commutation (T1') de l'autre circuit de commande (COM'), et
- chacun des deux circuits de commande (COM, COM') comprend un transistor supplémentaire (T3, T3') pour appliquer une tension de blocage comme tension de grille du transistor de commande du circuit de commande considéré, ledit transistor étant connecté entre la grille du transistor de commande en courant du circuit de commande considéré et la ligne de sélection qui lui est associée, et commandé sur sa grille par l'autre ligne de sélection associée à l'autre circuit de commande.

2. Ecran selon la revendication 1, **caractérisé en ce que** le circuit d'adressage comprend des drivers de commande des lignes et/ou des colonnes utilisés dans des écrans à cristaux liquides (LCD) pour piloter les lignes de sélection et/ou les lignes de données.

## Patentansprüche

1. Organisches Elektrolumineszenzdisplay mit n.m Pixeln, die matrixartig in m Reihen und n Spalten angeordnet sind, wobei jedes Pixel eine organische Diode (OLED) sowie einen ersten und einen zweiten Stromsteuerschaltkreis (COM,COM') für die Diode aufweist, welche jeweils Folgendes umfassen:
- einen Stromsteuerungstransistor (T2), der zwischen einer Referenzspannung und einer Elektrode (E1) der Diode geschaltet ist,
- einen Schalttransistor (T1) für die Schaltung einer Gitterspannung auf dem Gitter des Stromsteuerungstransistors,
- eine Kapazität (C1), die an das Gitter des Stromsteuerungstransistors angeschlossen ist, um die Gitterspannung aufrechtzuerhalten,
wobei ein Schaltkreis für die Adressierung der n.m Pixel konfiguriert ist, um eine Phase der Wiederherstellung auf einem Steuerungsschaltkreis eines Pixels durch Anlegen einer Blockierungsspannung (Vb) als Gitterspannung des jeweiligen Stromsteuerungstransistors und eine Phase der Anzeige auf dem anderen Steuerungsschaltkreis des Pixels durch Anlegen einer Videospannung (Vᵥ) als Gitterspannung des jeweiligen Stromsteuerungstransistors alternativ zu steuern,
**dadurch gekennzeichnet, dass**
der Adressierungsschaltkreis m Reihenauswahlzeilen umfasst, und zwar eine pro Matrixreihe, und die Pixel einer Matrixreihe mit einer jeweiligen Auswahlzeile (Si) der Reihe und mit einer anderen Auswahlzeile einer anderen Reihe verbunden sind, und n. Datenzeilen, und zwar eine pro Matrixspalte, je zum Anlegen einer Videospannung an ein Pixel einer jeweiligen Spalte und einer ausgewählten laufenden Reihe, und der Adressierungsschaltkreis konfiguriert ist, um jede der Auswahlzeilen des Displays sequentiell auszuwählen in der Richtung eines Abtastens des Displays von oben nach unten für ein Frame, und in der Richtung eines Abtastens des Display von unten nach oben für das nachfolgende Frame, und dass in jedem Pixel auf einer jeweiligen Reihe und Spalte der Matrix :
- die jeweilige Datenzeile (Dᵢ) mit den Schalttransistoren (T1, T1') der zwei zugeordneten Steuerungsschaltkreisen verbunden ist,
- die jeweilige Auswahlzeile (Sᵢ) mit dem Gitter des Schalttransistors (T1) eines der beiden Steuerungsschaltkreise (COM) verbunden ist,
- die andere Auswahllinie (Sᵢ₋₁,) mit dem Gitter des Schalttransistors (T1') des anderen Steuerungsschaltkreises (COM') verbunden ist und
- jeder der beiden Steuerungsschaltkreise (COM, COM') einen zusätzlichen Transistor (T3, T3') umfasst, um eine Blockierungsspannung als Gitterspannung des Steuerungstransistors des betreffenden Steuerungsschaltkreises anzulegen, wobei der Transistor zwischen dem Gitter des Stromsteuerungstransistors des betreffenden Steuerungsschaltkreises und der zugeordneten Auswahlzeile geschaltet ist und auf seinem Gitter durch die andere Auswahlzeile gesteuert wird, die dem anderen Steuerungsschaltkreis zugeordnet ist.

2. Display nach Anspruch 1, **dadurch gekennzeichnet, dass** der Adressierungsschaltkreis Treiber für die Steuerung der Zeilen und/der der Spalten aufweist, die in Flüssigkristalldisplays (LCD) benutzt werden, um die Auswahlzeilen und/oder Datenzeilen zu steuern.

## Claims

1. Organic light emitting screen comprising n.m image points organised in a matrix according to m rows and n columns, each image point comprising an organic light emitting diode (OLED) and a first and second current control circuit (COM,COM') for said LED, each one of them comprising:
- a current control transistor (T2) connected between a reference voltage and an electrode (E1) for said LED,
- a switching transistor (T1) to switch from a grid voltage to the grid of said current control transistor,
- a capacity (C1) connected to the grid of said current control transistor, to maintain said grid voltage, an addressing circuit for said n.m image points being configured to alternately control an image point recovery phase on a control circuit by applying a blocking voltage (Vb) as respective current control transistor grid voltage and an image point display phase on the other control circuit, by applying a video voltage (Vv) as respective current control transistor grid voltage, **characterised in that** The addressing circuit comprises m row selection lines, one per matrix row and the image points of a row of the matrix are connected to a respective selection line (Si) of said row and to another selection line of another row, and n data lines, one per matrix column, each one to apply a video voltage to an image point of a respective column and a selected current row, and the addressing circuit is configured to select in a sequence each one of the screen selection lines, in a vertical downward screen scanning direction for a frame, and in a vertical upward screen scanning direction for the next frame,
And **in that** each image point on a respective row and column of the matrix:
- the respective data line (Dᵢ) is connected to the switching transistors (T1, T1') of the two associated control circuits,
- the respective selection line (Sᵢ) is connected to the grid of the switching transistor (T1) of one of the two control circuits (COM),
- the other selection line (Sᵢ₋₁) is connected to the grid of the switching transistor (T1') of the other control circuits (COM') and,
- each one of the two control circuits (COM, COM') comprises an additional transistor (T3, T3') for the application of a blocking voltage as grid voltage of the control circuit transistor considered, said transistor being connected between the grid of the current control transistor of the control circuit considered and the associated selection line, and controlled on its grid by the other selection line associated with the other control circuit.

2. Screen according to claim 1, **characterised in that** the addressing circuit comprises control drivers for the lines and/or columns used in liquid crystal display (LCD) screens to control the selection lines and/or data lines.
